# EUROPÄISCHE PATENTSCHRIFT

(11) **EP 0 306 957 B1**
(45) Veröffentlichungstag und Bekanntmachung des Hinweises auf die Patenterteilung: **31.08.1994**
(21) Anmeldenummer: 88114703.7
(22) Anmeldetag: 08.09.1988
(51) Int. Cl.: H05K 13/02, H05K 13/00

(54) **Tablettartiges Aufnahmeteil**
Plate-like tray
Plateau sous forme de tablette

(30) Priorität: 08.09.1987 DE 3730129
(43) Veröffentlichungstag der Anmeldung: 15.03.1989
(73) Patentinhaber: Zarges, Frank W., Dipl.-Ing., D-82319 Starnberg (DE)
(72) Erfinder: Zarges, Frank W., Dipl.-Ing., D-82319 Starnberg (DE)
(74) Vertreter: Säger, Manfred, Dipl.-Ing.

(56) Entgegenhaltungen:
- EP-A- 0 161 594

## Beschreibung

Die Erfindung betrifft ein tablettartiges Aufnahmeteil gemäß dem Oberbegriff des Hauptanspruches.

Beim automatischen Bestücken von Printplatinen werden die Bauelemente mit zwei zueinander entgegengesetzten Anschlußdrähten, z.B. Widerstände etc. vom Band, andere Gegenstände, z.b. Printrelais in als Aufnahmeteilen dienenden sogenannten Trays zugeführt und von Robotern ergriffen, entnommen sowie an der bestimmten Stelle der Printplatine eingesetzt. Die Aufnahmeteile weisen sogenannte Nutzen, d.h. Aushöhlungen zur Aufnahme der Gegenstände auf, in die die Gegenstände mit den Anschlußfüßchen zum Einsetzen in die Printplatine nach unten abgelegt werden müssen, um im abgelegten Zustand gleich auf die Printplatine bzw. gedruckte Schaltung gesteckt werden zu können. Der Nutzen gibt einen definierten Lageort für die Gegenstände und eine definierte Lage am Ort vor, was für die Roboterentnahme erforderlich ist.

Solche an sich bekannten Aufnahmeteile, z.B. EP-A-0 161 594 werden durch Tiefziehen der Kunststoff-Folie hergestellt. Die darin enthaltenen Nutzen weisen nahe zu senkrecht zur Ebene der Kunststoff-Folie verlaufende Seitenwände auf, die fast parallel zur Tiefziehrichtung ausgerichtet sind. Infolgedessen werden die Seitenwände der Nutzen besonders dünn. Infolgedessen muß von einer relativ dicken Kunststoff-Folie ausgegangen werden. Es sind aufwendige Ziehverfahren und teuere Werkzeuge erforderlich. Insgesamt ergibt sich ein schlechtes Tiefziehverhältnis. Im übrigen ist jedes Aüfnahmeteil mit vorgegebenen Nutzen nur für eine Art von Gegenständen brauchbar, ganz abgesehen davon, daß die Gegenstände manuell schlecht entnehmbar sind.

Die Gegenstände, beispielsweise Printrelais haben an ihrer zumeist als Stanzteil hergestellten Grundplatte, die zugleich als Referenzebene dient, zumeist scharfe Kanten. Diese werden an den dünnsten Seitenwänden abgelegt. Die Gefahr eines Durchbruchs der Seitenwände oder einer Beschädigung ist latent vorhanden, so daß die Benutzungsdauer der bekannten Aüfnahmeteile beschränkt ist.

Der Erfindung liegt die Aufgabe zugrunde, ein gattungsgemäßes Aüfnahmeteil gemäß dem Oberbegriff des Hauptanspruchs so auszugestalten, daß es einfach und billig herstellbar ist sowie Nutzen mit stabilen Wänden für eine lange Nutzungsdauer aufweist.

Diese Aufgabe wird bei einem gattungsgemäßen Aufnahmeteil gemäß dem Oberbegriff des Hauptanspruchs erfindungsgemäß durch dessen kennzeichnende Merkmale gelöst. Die erfindungsgemäß vorhandene Auflagefläche und Stützfläche sind jeweils bezüglich der Tiefziehrichtung geneigt, so daß sich ein gutes Tiefziehverhältnis ergibt, ganz abgesehen davon, daß relativ dünne Kunststoff-Folien verwendet werden können und aufwendige Ziehverfahren und teuere Werkzeuge nicht erforderlich sind. Außerdem können die Gegenstände bei dieser Art der Anordnung der Auflagefläche und Stützfläche zur manuellen Entnahme übersichtlicher und greiffreundlicher angeboten werden. Schließlich können die Gegenstände bei paralleler Anordnung der Stütz- oder Auflagefläche zu der Manipulierebene, z.B. Printplatine, durch einen einfachen Bestückungsautomat entnommen und ohne Drehbewegung abgesetzt werden. Durch Vermeiden von Drehbewegungen bei den von den Bestückungsautomaten ausschließlich ausgeführten translatorische Bewegungen kann auf den Einsatz der teuren Roboter verzichtet werden.
In zweckmäßiger Ausgestaltung der Erfindung ist eine parallel zur Spur zwischen Stütz- und Auflagefläche verlaufende Führungsrinne vorgesehen, die vorzugsweise bis unter die Ebene der Stützfläche reicht und in diese mit einer Schrägfläche übergeht, wodurch selbst bei nicht exaktem Einsetzen der Gegenstände in den Nutzen diese mit ihren Anschlußfüßchen und der Führungsfläche in die richtige Endlage aufgrund der Schwerkraft rutschen. Hierbei ist die Führungsrinne so ausgestaltet, daß in der Endlage die in Verlängerung der Grundplatte angebrachten Anschlußfüßchen nicht an der Wand der Führungsrinne zur Anlage kommen, sondern nur die mit Bezug auf den Nutzen höher angeordneten Anschlußfüßchen, wodurch sich mit Bezug auf den Schwerpunkt des Gegenstandes ein besonders stabiles Gleichgewicht ergibt.

Weiterhin ist zur Verwendung des Aufnahmeteils für unterschiedlich große Gegenstände einer Gattung von Gegenständen. zum Beispiel Printrelais in einer Ausgestaltung der Erfindung vorgesehen, daß die Auflagefläche in Draufsicht eine im wesentlichen rechteckförmige, in ihren Umrissen an die Referenzfläche für die Grundfläche der Gegenstände angepaßte Vertiefung aufweist und daß in dieser zumindest eine weitere, demgegenüber kleinere und tiefer gelegene, rechteckförmige weitere Vertiefung vorgesehen ist.

Zweckmäßige Ausgestaltungen und Weiterbildungen der Erfindung sind in den Unteransprüchen gekennzeichnet.

Ein bevorzugtes Ausführungsbeispiel der Erfindung wird nachfolgend unter Bezugnahme auf die Zeichnung näher erläutert. In dieser zeigt:
- Figur 1: ein Aüfnahmeteil in schematischer Seitenansicht;
- Figur 2: eine Ansicht II gemäß Figur 1;
- Figur 3: eine Ansicht III gemäß Figur 1;
- Figur 4: die Einzelheit IV gemäß Figur 1 und
- Figur 5: eine Figur 4 ähnliche Darstellung mit einem eingesetzten Gegenstand in Form eines Printrelais.

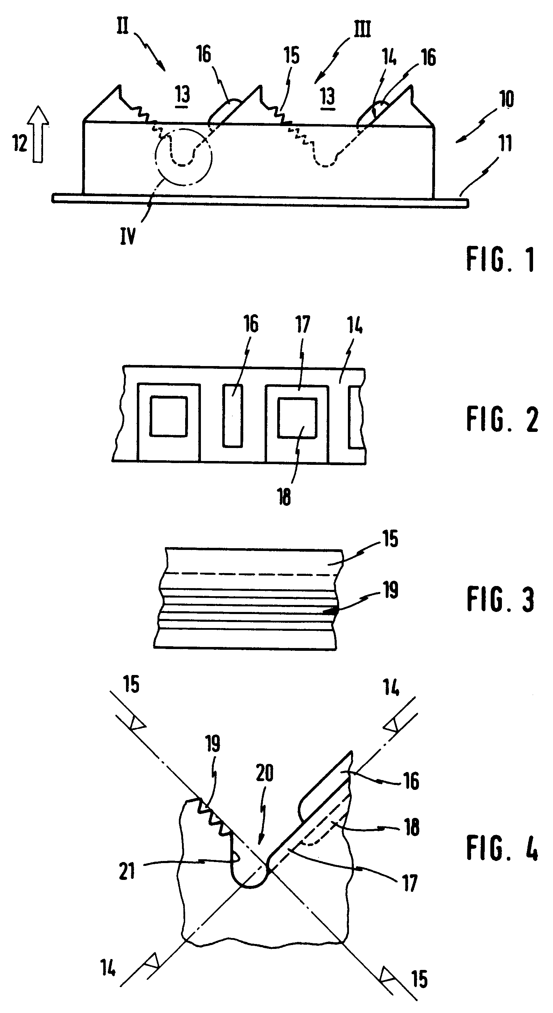

Das tablettartige Aufnahmeteil 10 gemäß Figr 1 ist aus einer Kunststoff-Folie in dazu gemäß Richtungspfeil 12 senkrechter Erstreckung der Ebene 11 tiefgezogenen und weist eine Vielzahl von sogenannten Nutzen zur Aufnahme von eine Referenzfläche vorgegebener Dimension und eine sich zu dieser winklig anschließenden Bestückungsseite mit Anschlußfüßchen aufweisenden Gegenständen, insbesondere Printrelais auf. Die Nutzen 13 sind matrixartig in Reihen und Spalten in dem Tray angeordnet. (in Fig. 1 sind in Draufsicht zwei nebeneinanderliegende Reihen von Nutzen gezeigt). In einer Reihe liegen die Nutzen nebeneinander (in Fig. 1 parallel zur Zeichenebene hintereinander).

Der Nutzen weist nur zwei Flächen, nämlich die der Referenzfläche des Gegenstands angepaßte Auflagefläche 14 und eine rechtwinklig dazu verlaufende Stützfläche 15 auf. Zwischen zwei Nutzen einer Reihe ist eine Trennrippe 16 vorgesehen, die über die Auflagefläche über eine erste Ebene vorspringt, in der alle Auflageflächen 14 einer Reihe von Nutzen 13 liegen.

Die Auflagefläche 14 weist ferner in Draufsicht eine im wesentlichen rechteckförmige, in ihren Umrissen an die Referenzfläche angepaßte erste Vertiefung 17 (Fig. 2) sowie zumindest eine, demgegenüber kleinere, ebenfalls rechteckförmige weitere Vertiefung 18 auf, die bezüglich der ersten Ebene in die gleiche Richtung vertieft ist.

Die Stützflächen 15 einer Reihe von Nutzen 13 liegen auch sämtlich in einer zu der ersten Ebene beim wiedergegebenen Ausführungsbeispiel senkrecht angeordneten zweiten Ebene. Sie können eine Vielzahl von parallel zur Spur der ersten mit der zweiten Ebene verlaufende Rillen 19 aufweisen (Fig. 3).

Ferner ist, wie Fig. 4 zeigt, am Ende beider Flächen, der Stütz- und der Auflagefläche eine insgesamt mit 20 bezeichnete Führungsrinne vorgesehen, die bis unter die zweite Ebene der Stützfläche 15 reicht und mit einer Schrägfläche 21 in die Stützfläche 15 übergeht.

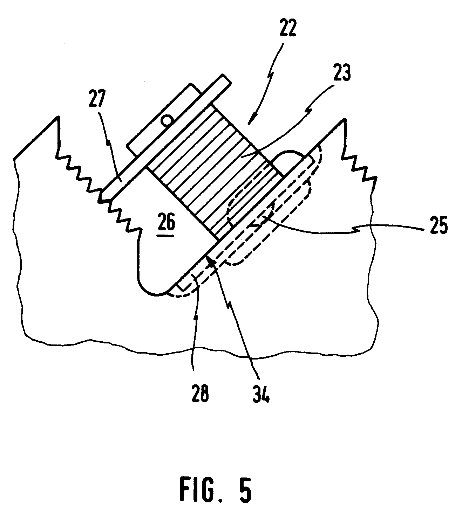

Fig. 5 zeigt einen schematischen Querschnitt durch einen Nutzen 13 mit einem eingesetzten Gegenstand, hier einem Printrelais 22. Aus Gründen der Übersichtlichkeit sind die Bezugszeichen für den Nutzen etc. weggelassen worden. Die Ansicht, Lage und Bezugszeichen entsprechen aber jenen gemäß Fig. 4. Das Printrelais 22 weist eine Spule 23 mit einem über die Grundplatte 34 überstehenden Spulenkern 25 auf, wobei die Grundplatte als Referenzebene dient. Die Grundplatte 34 liegt in der ersten rechteckförmigen Vertiefung 17. Die Bestückungsseite 26 des Printrelais 22 ist der Stützfläche 15 zugewandt. Auf dieser Bestückungsseite 26 sind obere Anschlußfüßchen 27 und untere, an der Grundplatte 34 vorgesehene Anschlußfüßchen 28 vorgesehen. In der ein gesetzten, in Fig. 5 wiedergegebenen Lage stützen sich nur die oberen Anschlußfüßchen 27 in einer Rille 19 der Stützfläche 15 ab. Die unteren Anschlußfüßchen 28 enden frei in der Führungsrinne 20.

## Patentansprüche

1. Tablettartiges Aufnahmeteil in Form einer tiefgezogenen Kunststofffolie mit einer Vielzahl von matrixartig angeordneten, auch Nutzen (13) genannten Aushöhlungen zur Aufnahme von Gegenständen, wobei der Nutzen Wandungen aufweist, die zur Ebene (11) der unverformten Kunststoffolie senkrechten Tiefziehrichtung (12) winklig verlaufen,
**dadurch gekennzeichnet**,
daß die Wandungen der Nutzen (13) von je zwei Flächen gebildet werden, daß die zwei Flächen als Auflagefläche (14) und Stützfläche (15) ausgebildet sind, daß die Stützfläche (50) sich winklig zu der Auflagefläche (14) anschließt, daß diese zu der Ebene der unverformten Kunststoffolie (11) einen Winkel von 20° bis 70° einschließt, daß sowohl die Auflagefläche (14) als auch die Stützfläche (15) gegenüber der Tiefziehrichtung (12) geneigt sind, daß alle Auflageflächen (14) einer Reihe von Nutzen (13) in einer ersten Ebene liegen, daß alle Stützflächen (15) einer Reihe in einer zweiten Ebene liegen und daß zwischen zwei benachbarten Nutzen (13) einer Reihe eine über die erste oder zweite Ebene vorspringende Trennrippe (16) angeordnet ist.

2. Tray nach Ansprüche 1, **dadurch gekennzeichnet**, daß die erste Ebene senkrecht zu der zweiten Ebene verlaüft.

3. Tray nach einem der Ansprüche 1 bis 2, **dadurch gekennzeichnet**, daß die Auflagefläche (14) eine erste Vertiefung (17) aufweist.

4. Tray nach Anspruch 3, **dadurch ge****kennzeichnet**, daß in der ersten Vertiefung (17) zumindest eine demgegenüber kleinere, weitere Vertiefung (18) vorgesehen ist.

5. Tray nach einem der Ansprüche 1 bis 4, **dadurch** **gekennzeichnet**, daß die Stützfläche (15) eine parallel zu dem an die Auflagefläche (14) angrenzenden Bereich verlaufende Führungsrinne (20) aufweist und daß vorzugsweise die Führungsrinne (20) bis unter die Stützfläche (15) reicht.

6. Tray nach Anspruch 5, **dadurch ge****kennzeichnet**, daß die Schnittlinie der ersten und zweiten Ebene im Bereich der Führungsrinne (20) liegen.

7. Tray nach einem der Ansprüche 1 bis 6, **dadurch** **gekennzeichnet**, daß die Stützfläche (15) außerhalb des Bereichs der Führungsrinne (20) mit parallel zu dieser verlaufenden Rillen (19) versehen ist.

## Claims

1. A tray-like holder in the form of a deep-drawn synthetic resin sheet comprising a plurality of hollows arranged in the form of a matrix and also referred to as cavities (13), for the accommodation of objects, wherein the cavity possesses walls which extend at an angle to the deep-drawing direction (12) perpendicular to the plane (11) of the unshaped synthetic resin sheet, characterised in that the walls of the cavities (13) are formed in each case by two surfaces, that the two surfaces have the form of a bearing surface (14) and a support surface (15), that the support surface (50) adjoins the bearing surface (14) at an angle, that the bearing surface (14) forms an angle of 20° to 70° with the plane of the unshaped synthetic resin sheet (11), that both the bearing surface (14) and the support surface (15) are inclined in relation to the deep-drawing direction (12), that all the bearing surfaces (14) of a row of cavities (13) are arranged in a first plane, that all the support surfaces (15) of a row are arranged in a second plane, and that a separating rib (16) projecting beyond the first or second plane is arranged between two adjacent cavities (13) of a row.

2. A tray as claimed in Claim 1, characterised in that the first plane extends at right angles to the second plane.

3. A tray as claimed in one of Claims 1 to 2, characterised in that the bearing surface (14) comprises a first recess (17).

4. A tray as claimed in Claim 3, characterised in that in the first recess (17) there is provided at least one comparatively smaller, further recess (18).

5. A tray as claimed in one of Claims 1 to 4, characterised in that the support surface (15) comprises a guide channel (20) extending in parallel to the zone adjoining the bearing surface (14), and that preferably the guide channel (20) extends to beneath the support surface (15).

6. A tray as claimed in Claim 5, characterised in that the intersecting line of the first and second planes is located in the region of the guide channel (20).

7. A tray as claimed in one of Claims 1 to 6, characterised in that the support surface (15) is provided outside of the region of the guide channel (20) with grooves (19) extending in parallel to said channel.

## Revendications

1. Plateau sous forme de tablette ayant la forme d'un film en matière plastique traité par emboutissage profond et comportant une pluralité de cavités, appelées également logements (13), disposées de manière matricielle pour la réception d'objets, lesdits logements présentant des parois formant un certain angle avec le plan (11), perpendiculaire au sens d'emboutissage (12) et du film en matière plastique avant emboutissage, caractérisé en ce que les parois des logements (13) sont constituées par respectivement deux faces en ce que ces deux faces sont réalisées en face d'appui (14) et en face de renfort (15), en ce que la face de renfort (15) se raccorde de manière angulaire à la face d'appui (14), en ce que cette dernière forme avec le plan du film (11), avant emboutissage, un angle de 20 à 70°, en ce que, aussi bien la face d'appui (14) que la face de renfort (15), sont inclinées par rapport au sens de l'emboutissage (12), en ce que toutes les faces d'appui (14) d'une rangée de logements (13) sont situées dans un premier plan, en ce que toutes les faces d'appui (15) d'une rangée sont situées dans un deuxième plan, et en ce que, entre deux logements voisins (13) d'une rangée, est disposée une nervure de séparation (16) faisant saillie au delà du premier ou du deuxième plan.

2. Plateau selon la revendication 1, caractérisé en ce que le premier plan s'étend perpendiculairement au deuxième plan.

3. Plateau selon l'une des revendications 1 à 2, caractérisé en ce que la face d'appui (14) présente un premier évidement (17).

4. Plateau selon la revendication 3, caractérisé en ce que dans l'évidement (17) est prévu au moins un autre évidement (18) plus petit que le premier.

5. Plateau selon l'une des revendications 1 à 4, caractérisé en ce que la face de renfort (15) présente une gorge de guidage (20) s'étendant parallèlement à la zone limite de la face d'appui (14) et en ce que cette gorge (20) parvient, de préférence, jusqu'en dessous de ladite face de renfort (15).

6. Plateau selon la revendication 5, caractérisé en ce que la ligne de coupe du premier et du deuxième plans se situe chacune au voisinage de la gorge de guidage (20).

7. Plateau selon l'une des revendications 1 à 6, caractérisé en ce que la face de renfort (15) est munie, à l'extérieur de la zone où se trouve la gorge de guidage (20), de rainures (19) s'étendant parallèlement à cette gorge (20).
